(19) **Europäisches Patentamt**

**European Patent Office**

**Office européen des brevets**

(11) **EP 1 703 290 A1**

(12) **EUROPEAN PATENT APPLICATION**
published in accordance with Art. 158(3) EPC

(43) Date of publication:
**20.09.2006 Bulletin 2006/38**

(51) Int Cl.:
*G01R 31/00* (2006.01)    *H01G 9/155* (2006.01)

(21) Application number: **05816789.1**

(86) International application number:
**PCT/JP2005/022836**

(22) Date of filing: **13.12.2005**

(87) International publication number:
**WO 2006/064786 (22.06.2006 Gazette 2006/25)**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **14.12.2004  JP 2004361166**

(71) Applicant: **MATSUSHITA ELECTRIC INDUSTRIAL CO., LTD.**
**Osaka 571-8501 (JP)**

(72) Inventors:
• **OHASHI, T.**
**Matsushita Electric Industrial Co.,Ltd.**
**Osaka-shi**
**Osaka 540-6319 (JP)**

• **MITANI, Y.**
**Matsushita Electric Industrial Co.,Ltd.**
**Osaka-shi, Osaka 540-6319 (JP)**
• **MORITA, K.**
**Matsushita Electric Industrial Co.,Ltd.**
**Osaka-shi, Osaka 540-6319 (JP)**
• **ODAJIMA, Y.**
**Matsushita Electric Industrial Co.,Ltd**
**Osaka-shi, Osaka 540-6319 (JP)**
• **TAKEMOTO, J.**
**Matsushita Electric Industrial Co,Ltd**
**Osaka-shi**
**Osaka 540-6319 (JP)**

(74) Representative: **Balsters, Robert et al**
**Novagraaf International SA**
**25, avenue du Pailly**
**1220 Les Avanchets - Geneva (CH)**

(54) **POWER SUPPLY DEVICE**

(57)    A power supply device has capacitor unit (7) in which capacitors are interconnected in series, charging unit (8) for charging capacitor unit (7) at a constant current, detecting unit (6) for detecting voltage on the high potential side of each of the capacitors, determining unit (4) for determining the existence of an abnormality based on the voltage detected by detecting unit (6). The determining unit determines the abnormality when the difference between respective voltages on the high potential sides of some adjacent capacitors exceeds upper-limit voltage value Va, when the difference is lower than lower-limit voltage value Vb, or when a voltage is negative.

FIG. 1

EP 1 703 290 A1

**Description**

**TECHNICAL FIELD**

The present invention relates to detection of an abnormality of a capacitor in a power supply device for storing electricity in the capacitor.

**BACKGROUND ART**

A capacitor unit of a large capacity used for storing electricity of the power supply device is generally used for stabilizing a main power supply during load variation. The severest application is usage as a power supply for a backup operation when the main power supply fails. High reliability is required when the capacitor unit is applied to a braking system mounted in a vehicle, for example. For detecting a degradation state of the capacitor unit, a method is known, in which resistance or capacity of the capacitor unit is measured and the degradation state of the capacitor unit during charge is monitored. Additionally, another method is known in which a discharge circuit disposed in parallel with a capacitor disposed in the capacitor unit is operated and the voltage of the capacitor is brought into balance when a predetermined voltage or higher is applied to the capacitor.

As conventional art document information related to the present invention, Japanese Patent Unexamined Publication No. H10-174285 is known, for example.

However, even when an abnormality occurs in a single capacitor, it is disadvantageously difficult to detect the abnormality as a large variation in the whole capacitor unit. When a balance operation circuit fails, the abnormality cannot be detected. When a backup operation by the capacitor unit is required in an emergency state, the operation is not guaranteed.

**SUMMARY OF THE INVENTION**

A power supply device of the present invention has the following elements: a capacitor unit in which capacitors are interconnected in series or in series-parallel; a charging unit for charging the capacitor unit at a constant current; a detecting unit for detecting voltage on the high potential side of each of the capacitors; a determining unit for determining the existence of an abnormality based on the voltage detected by the detecting unit; and a communication unit for outputting a determining result from the determining unit. The determining unit determines the abnormality when difference between respective voltages on the high potential sides of some adjacent capacitors exceeds upper-limit voltage value $Va$, when the difference is lower than lower-limit voltage value $Vb$, or when one of respective voltages is negative. Thus, by detecting an abnormal voltage applied to each capacitor or a short failure, the abnormality detection of the capacitor unit is enabled, and hence the high reliability can be guaranteed.

**BRIEF DESCRIPTION OF DRAWINGS**

Fig. 1 is a block diagram of a power supply device in accordance with an exemplary embodiment of the present invention.
Fig. 2 is a diagram explaining the voltage on the high potential side of the capacitor unit in accordance with the exemplary embodiment.
Fig. 3 is a diagram explaining the relation between the cell-short time and capacity variation in the capacitor unit in accordance with the exemplary embodiment.
Fig. 4 is a diagram showing a case where the capacitor unit is formed by series-parallel connection, in which N capacitors are interconnected in series-parallel where M series are interconnected, in accordance with the exemplary embodiment.

**REFERENCE MARKS IN THE DRAWINGS**

1    battery
2    power supply device
3    electronic device mounted on a vehicle
4    determining unit

5       communication unit
6       detecting unit
7       capacitor unit
8       charging unit
9       communication output terminal
10      backup output terminal

**DETAILED DESCRIPTION OF PREFERRED EMBODIMENT (EXEMPLARY EMBODIMENT)**

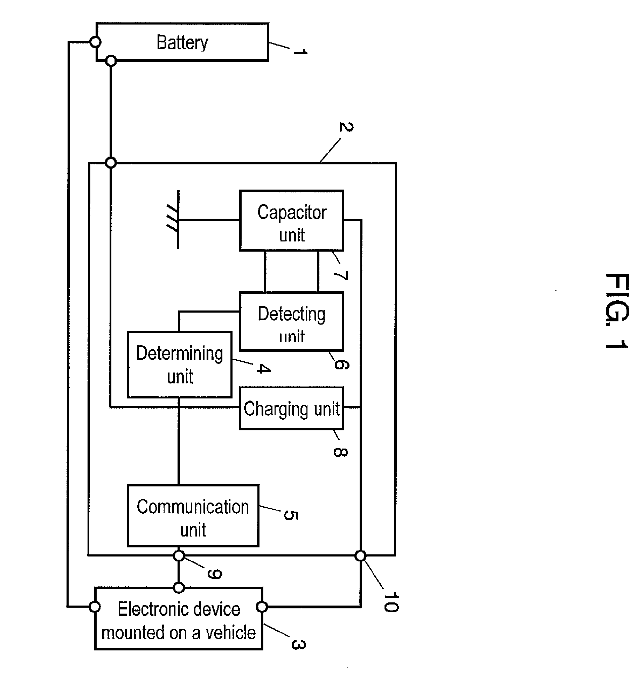

An exemplary embodiment of the present invention will be hereinafter described with reference to the drawings. Fig. 1 is a block diagram of a power supply device having capacitors for storage as an emergency backup power supply device for an electronic device mounted on a vehicle.

For extending the life of capacitor unit 7 formed of electrical double layer capacitors, capacitor unit 7 is needed to be kept in no charge state while being not used. The capacitor unit is discharged when a user gets off a vehicle, and is charged from a battery when the user gets on the vehicle. When the capacitor unit is recharged as necessary in use, it is charged at a constant current by charging unit 8. When battery 1 comes off to turn off power, namely in an emergency, capacitor unit 7 applies energy to electronic device 3 mounted on the vehicle through backup output terminal 10.

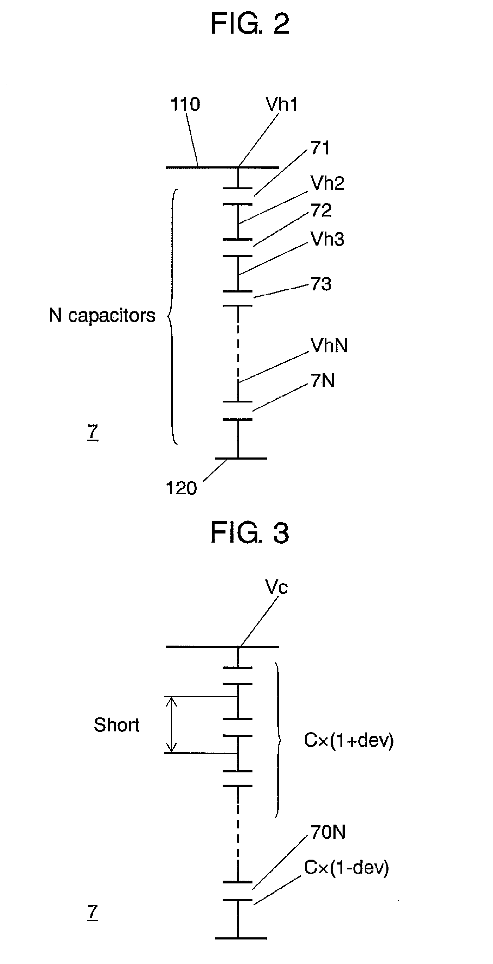

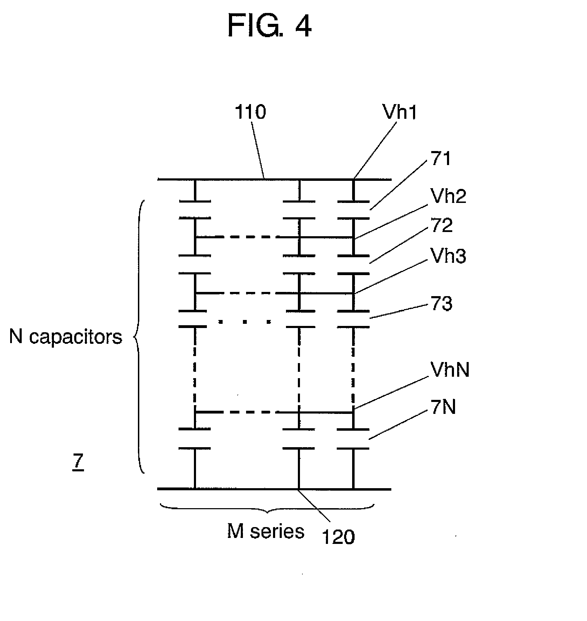

Fig. 2 is a diagram explaining the voltage on the high potential side of the capacitor unit in accordance with the exemplary embodiment of the present invention. In capacitor unit 7 of Fig. 2, N capacitors 71, 72, 73 ... 7N are interconnected in series, and the both ends thereof are connected to output terminal 110 and ground terminal 120, respectively. The example where all of capacitors 71 through 7N are interconnected in series is described hereinafter, but they may be interconnected in series-parallel. The N is called series number. In other words, only series connection is employed as in Fig. 2, the number of capacitors is equivalent to series number N. Fig. 4 is a diagram showing a case where a capacitor unit of the exemplary embodiment of the present invention is formed by series-parallel connection, in which N capacitors are interconnected in series-parallel where M series are interconnected in parallel. Assuming N is 4 and M is 3, for example in Fig. 4, four capacitors are interconnected in series and three series of capacitors are interconnected in parallel, thereby forming a capacitor unit in a matrix shape. In this case, series number N is 4.

While capacitor unit 7 is being charged, detecting unit 6 monitors voltage during charge of each capacitor, and transmits the voltage value to determining unit 4. The voltage applied to a capacitor is determined as the difference between respective voltages on the high potential sides of the capacitor and its adjacent capacitor, as shown in Fig. 2. For example, the voltage value on the high potential side of the uppermost capacitor 71 is Vh1 and the voltage value on the high potential side of capacitor 72 just described under capacitor 71 is Vh2, so that the voltage applied to the uppermost capacitor 71 is determined as Vh1 - Vh2. Note that one side of the lowermost capacitor 7N is connected to ground terminal 120, so that the potential on this side is zero. The voltage applied to capacitor 7N is determined as VhN without taking difference.

It is recommended that upper-limit voltage value Va determined by determining unit 4 is set as withstand voltage value Vt per capacitor cell.

When there's no capacity variation among capacitors, the voltage of each capacitor is usually defined as 1/N of charge voltage Vc applied between output terminal 110 and ground terminal 120 of the capacitor unit. When an abnormality occurs in the charge circuit or there are capacity variations of the capacitors, however, an abnormality such as disablement of charge and a short failure can be determined when the voltage of a capacitor is lower than at least half of the above-mentioned value, namely

$$Vc\,/\,(2N).$$

Therefore, lower-limit voltage value Vb determined by determining unit 4 is set at this value. When the voltage of a capacitor is negative, an abnormality is determined for securing safety of the circuit or the capacitor.

Next, voltage at which the determination is started is described.

Fig. 3 is a diagram showing the relation between the cell-short time and capacity variation in the capacitor unit in accordance with the exemplary embodiment. When there is the capacity variation of the capacitors and a short failure occurs, the voltage corresponding to the short-failed capacitor is additionally applied to the remaining capacitors as shown in Fig. 3. Degree of the capacity variation is shown by "dev". When the lowermost capacitor 70N has value C × (1 - dev), namely the lower limit of the capacity variation, and the remaining capacitors have value C × (1 + dev), namely the upper limit of the capacity variation, for example as shown in Fig. 3, voltage Vk in charging the lowermost capacitor 70N is maximum.

Assuming that the number of series stages including a capacitor having short failure is at M, and the series number is at N. Also assuming that, one capacitor of the capacitors that are not short-failed has the lower-limit capacity variation value, and the remaining capacitors have the upper-limit capacity variation value. At this time, when the voltage value in charging the capacitor having the lower-limit capacity variation value is set at Vk, and the voltage value in charging the capacitor having the upper-limit capacity variation value is set at Vj, the following relation is satisfied,

$$Vk + (N - 1 - M) \times Vj = Vc \qquad (Eq. 1).$$

Number M of series stages is the number of short-failed capacitors in the case of only series connection of Fig. 3. In the case of series-parallel connection, even if only one of the capacitors in the series direction is short-failed, the other capacitor connected to the capacitor in parallel is in short-circuiting. Therefore, the number of stages (parallel direction) including the short-failed capacitors is set at M. As a result, when a plurality of capacitors in the same stage are short-failed, M is counted as one.

The same charge current flows through the capacitors interconnected in series, so that the capacity of each capacitor is inversely proportional to the voltage at charge time. Therefore, the following relation is satisfied,

$$Vk / Vj = (1 + dev) / (1 - dev) \qquad (Eq. 2).$$

Using the two equations, Vk is derived as below,

$$Vk = Vc \times \{ 1 / (1 - dev) \} / \{ (N - 1 - M) / (1 + dev) + 1 / (1 - dev) \} \qquad (Eq. 3).$$

When voltage value Vk is set as withstand voltage value Vt of the capacitor, voltage value Vc at charge time at this time is derived using Vt as below,

$$Vc = Vt \times \{ 1 + (N - 1 - M) \times (1 - dev) / (1 + dev) \} \qquad (Eq. 4).$$

Therefore, considering that Vc includes detection error margin $\alpha$ such as a measuring error, predetermined voltage value Vd at the start of determination is set as below,

$$Vd = Vt \times \{ 1 + (N - 1 - M) \times (1 - dev) / (1 + dev) \} - \alpha.$$

Therefore, when the determination is started at the time when Vc is voltage value Vd or lower, the abnormality can be detected before over-voltage is applied to the capacitor at abnormal time. Specifically, when the full charge voltage of the capacitor is set at Vf, for example, it is recommended that the determination is performed by the time when Vc reaches Vd = 0.8 Vf.

When these abnormalities are determined, communication unit 5 transmits a signal indicating the abnormalities from communication output terminal 9 to an external system such as an electronic device mounted on a vehicle of Fig. 3. Thus, the external system can secure a safe operation as the whole system.

As a result, the abnormality of the capacitor can be detected, and high reliability can be achieved. Additionally, determination processing that handles many capacitors does not need to be started just after the start of the charge of capacitors. Here, at the start time of the charge, control processing becomes dense and the load of the calculation processing becomes heavy. The determination processing may be started at the time when the load of the calculation processing is light at Vd or lower, for example at the time of Vc = 0.5 Vf. Therefore, the load of the calculation processing is light, such determination processing is useful in abnormality detection, and the advantage is large.

**INDUSTRIAL APPLICABILITY**

A power supply device of the present invention for determining an abnormality of a capacitor has high reliability, and is useful as a power supply device for charging the capacitor.

**Claims**

1.   A power supply device comprising:

a capacitor unit in which capacitors are interconnected in series or in series-parallel;
a charging unit for charging the capacitor unit at a constant current;
a detecting unit for detecting voltage on a high potential side of each of the capacitors;
a determining unit for determining existence of an abnormality based on the voltage detected by the detecting unit; and
a communication unit for outputting a determining result from the determining unit,
wherein the determining unit determines the abnormality when difference between respective voltages on the high potential sides of adjacent capacitors in the capacitors exceeds an upper-limit voltage, when the difference is lower than a lower-limit voltage, or when a voltage value is negative.

2.   The power supply device according to claim 1,
wherein the upper-limit voltage is set as a withstand voltage value per one cell of the capacitors.

3.   The power supply device according to claim 1,
wherein lower-limit voltage value "Vb" is expressed by

$$\mathrm{Vb} = \mathrm{Vc} / (2\mathrm{N}),$$

where "Vc" is a charge voltage value of the capacitor unit and "N" is series number of the capacitors.

4.   The power supply device according to claim 1,
wherein the determination is started at the time when a charge voltage value of the capacitor unit is at most a predetermined voltage value.

5.   The power supply device according to claim 4,
wherein the predetermined voltage value, "Vd" is expressed by

$$\mathrm{Vd} = \mathrm{Vt} \times \{\, 1 + (\mathrm{N} - 1 - \mathrm{M}) \times (1 - \mathrm{dev}) / (1 + \mathrm{dev})\,\} - \alpha,$$

where "Vt" is a withstand voltage value per one cell of the capacitors, "dev" is a capacity variation of the capacitors, "N" is the total number of the capacitors, "M" is the number of series stages including short-failed capacitors, and "α" is a detection error margin.

# FIG. 1

# FIG. 2

# FIG. 3

# FIG. 4

## INTERNATIONAL SEARCH REPORT

| International application No. |
| --- |
| PCT/JP2005/022836 |

**A. CLASSIFICATION OF SUBJECT MATTER**
*G01R31/00*(2006.01), *H01G9/155*(2006.01)

According to International Patent Classification (IPC) or to both national classification and IPC

**B. FIELDS SEARCHED**

Minimum documentation searched (classification system followed by classification symbols)
G01R31/00, H01G9/155, H02J7/00

Documentation searched other than minimum documentation to the extent that such documents are included in the fields searched
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP 2000-287373 A (Shizuki Electric Co., Inc.), 13 October, 2000 (13.10.00), Full text; all drawings (Family: none) | 1-5 |
| Y | JP 2004-088869 A (JEOL Ltd.), 18 March, 2004 (18.03.04), Par. Nos. [0032] to [0045]; Figs. 5 to 7 (Family: none) | 1-5 |
| Y | JP 4-042068 A (Toshiba Corp.), 12 February, 1992 (12.02.92), Full text; all drawings (Family: none) | 1-5 |

☐ Further documents are listed in the continuation of Box C.  ☐ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 06 March, 2006 (06.03.06) | 20 March, 2006 (20.03.06) |

| Name and mailing address of the ISA/ | Authorized officer |
| --- | --- |
| Japanese Patent Office | |
| Facsimile No. | Telephone No. |

Form PCT/ISA/210 (second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H10174285 A